Europäisches Patentamt

European Patent Office

Office européen des brevets

(11) Veröffentlichungsnummer: **0 310 965**
**A2**

(12) **EUROPÄISCHE PATENTANMELDUNG**

(21) Anmeldenummer: 88116209.3

(22) Anmeldetag: 30.09.88

(51) Int. Cl.⁴: **H01R 29/00**

(30) Priorität: **01.10.87 DE 3733264**

(43) Veröffentlichungstag der Anmeldung:
**12.04.89 Patentblatt 89/15**

(84) Benannte Vertragsstaaten:
**AT BE CH DE ES FR GB GR IT LI LU NL SE**

(71) Anmelder: **MÖSTRONIK-UNISEL elektronische Geräte GmbH**
**Föhringer Allee 5**
**D-8043 Unterföhring(DE)**

(72) Erfinder: **Bauer, Herbert**
**Sonnenstrasse 3**
**D-8011 Aschheim(DE)**

(74) Vertreter: **Prüfer, Lutz H., Dipl.-Phys.**
**Harthauser Strasse 25d**
**D-8000 München 90(DE)**

(54) **Elektronische Einrichtung.**

(57) Bei elektronischen Einrichtungen ist die Steckerbelegung durch die gerätespezifische geometrische Anordnung der mit den Steckern zu verbindenden Leitung festgelegt. Dadurch wird die Variabilität der Einsetzbarkeit der Geräte begrenzt. Mit der neuen elektronischen Einrichtung wird eine variable Belegung der Stecker in Abhängigkeit von dem gewünschten Einsatzzweck ermöglicht.

Damit die Variabilität erreicht wird, ist leitungsseitig eine Unterbrechung wenigstens eines Teiles der Leitungen vorgesehen. Die Unterbrechung wird mit einer Verbindungseinrichtung (17) zum wählbaren Verbinden der Leitungen mit vorbestimmten Steckern vorgesehen.

Die Erfindung ist insbesonder bei elektronischen Einrichtungen wie etwa Schaltnetzteilen anwendbar.

FIG.1

EP 0 310 965 A2

## ELEKTRONISCHE EINRICHTUNG

Die Erfindung betrifft eine elektronische Einrichtung nach dem Oberbegriff des Anspruches 1.

Aus der DE-AS 19 02 431 ist eine elektronische Einrichtung nach dem Oberbegriff des Patentanspruches 1 bekannt. Bei dieser sind Verbindungsstecker vorgesehen, die so ausgebildet sind, daß die Verbindungsstifte der einen Gruppe durch Verbindungsstecker mit den Verbindungsstiften der anderen Gruppe verbindbar sind. Aus der DE-OS 35 02 295 ist ein Aufbausystem für Geräte der elektrischen Nachrichtentechnik bekannt, bei dem Steckbaugruppen vorgesehen sind, die Steckverbinder mit Eingängen und Ausgängen, die durch ein Matrix-Koppelfeld miteinander verbindbar sind, aufweisen. Im allgemeinen wird bei elektronischen Geräten die Steckerbelegung bei der Herstellung festgelegt. Der Anwender ist an die einmal gewählte Ausführung gebunden. Der universelle Einsatz solcher Geräte und ihrer Austauschbarkeit gegen neue Produkte oder Produkte anderer Hersteller ist dadurch begrenzt. Aus der DE-OS 19 12 883 ist eine Programmsteckkarte bekannt mit sich kreuzenden Leitungen auf den einander entgegengesetzten Seiten der Karte, die durch eingelötete Leitungsstücke miteinander verbindbar sind.

Aufgabe der Erfindung ist es, eine elektronische Einrichtung der eingangs beschriebenen Art so zu gestalten, daß die Steckerbelegung auf einfache Weise variabel gestaltet und an die gewünschte Steckerbelegung anpaßbar ist.

Diese Aufgabe wird durch eine in Patentanspruch 1 gekennzeichnete elektronische Einrichtung gelöst.

Ausführungsbeispiele der Erfindung werden im weiteren unter Bezugnahme auf die Figuren beschrieben. Von den Figuren zeigen:

Fig. 1 eine schematische Darstellung eines Schaltnetzteiles in Draufsicht;

Fig. 2 eine perspektivische Ansicht einer Verbindungseinrichtung; und

Fig. 3 eine Draufsicht auf eine abgewandelte Ausführungsform einer Verbindungseinrichtung.

Bei dem gezeigten Ausführungsbeispiel ist die elektronische Einrichtung als Schaltnetzteil 1 ausgebildet. Dieses umfaßt in bekannter Weise Eingangsfilter und Sicherungen 2, eine Ansteuerelektronik 3, einen Trafo 4, ein Leistungsteil 5, eine Primär-Sekundär-Trennstrecke 6, eine Steuerelektronik 7, Opto-Koppler 8, 9, die auf einer Leiterplatte 10 angeordnet sind.

Ausgangsseitig ist eine Steckerleiste 11 mit einer Mehrzahl von eine feste geometrische Zuordnung zueinander aufweisenden Steckern 12 vorgesehen. Geräteseitig sind die Stecker jeweils mit Leitungsanschlüssen 13 verbunden, die zu den Potential- und Steuerleitungen führen. Die geometrische Anordnung der Potential- und Steuerleitungen 14 ist durch die vom Hersteller gewählte Geometrie der elektronischen Einrichtung festgelegt.

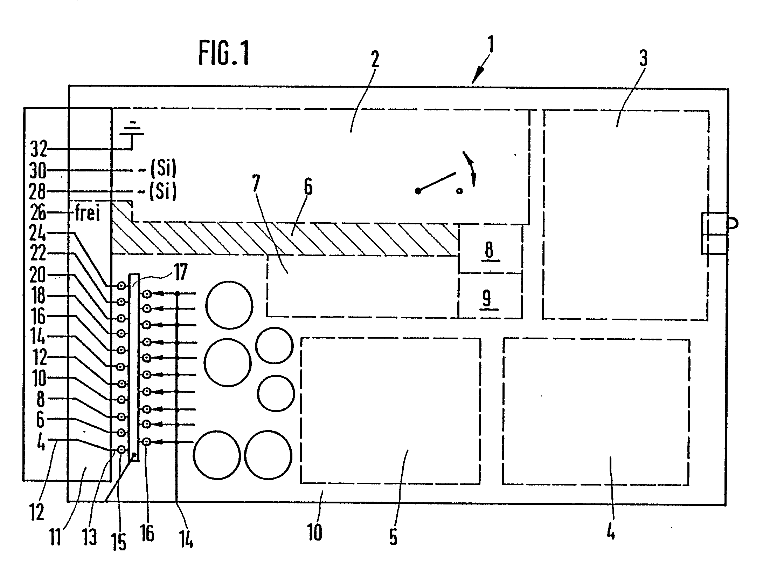

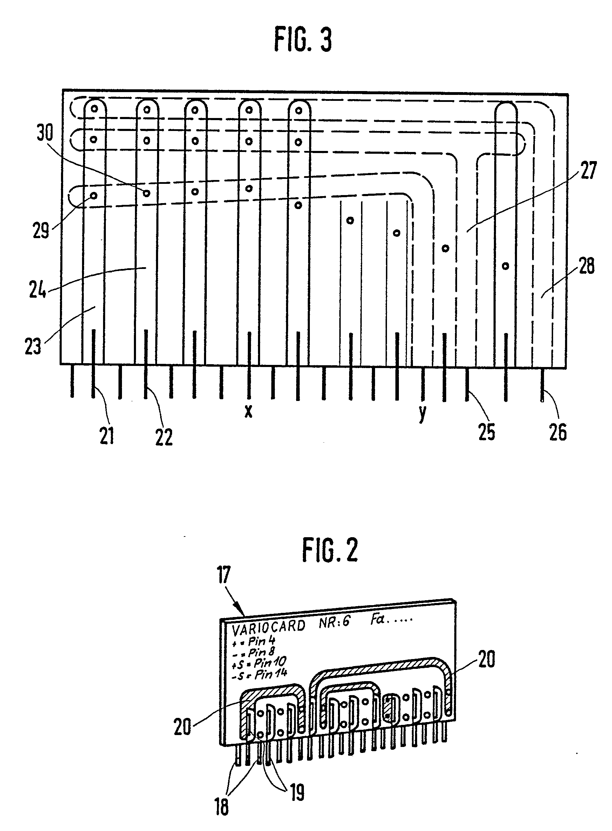

Wie aus Fig. 1 ersichtlich ist, ist leitungsseitig zwischen einer Mehrzahl der Leitungen und einer entsprechenden Mehrzahl von Steckern eine Unterbrechung vorgesehen. An den jeweiligen die Unterbrechung begrenzenden Leitungsenden sind Bohrungen 15, 16 vorgesehen. Zur Überbrückung der Unterbrechungen dient eine am besten aus Fig. 2 ersichtliche, platinenartige Verbindungseinrichtung 17. Diese Einrichtung weist eine wenigstens der Anzahl der unterbrochenen Leitungen entsprechende Anzahl von ersten Steckern 18 auf einer Seite der platinenartigen Verbindungseinrichtung 17 und eine entsprechende Anzahl zweiter stecker 19 auf der gegenüberliegenden Seite der platinenartigen Verbindungseinrichtung auf. Die ersten Stecker 18 sind in einer durch die beabsichtigte Anwendung vorbestimmten Weise durch Leiterbahnen 20 mit einem der zweiten Stekcer 19 verbunden. Die Stecker der beiden Gruppen sind geometrisch so angeordnet, daß sie zusammen mit einer platinenartigen Verbindungseinrichtung 17 in der in Fig. 1 gezeigten Weise in die beiden Gruppen der Bohrungen 15, 16 einsteckbar und beispielsweise verlötbar und somit mit den Potential-Steuerleitungen 14 bzw. den zu den Steckern führenden Leitungsenden leitend verbindbar sind. Auf diese Weise wird erreicht, daß unabhängig von der gerätespezifischen geometrischen Anordnung der Potential- und Steuerleitungen die Stecker 12 der Steckerleiste eine kundenspezifische Belegung aufweisen.

Bei der in Fig. 3 gezeigten Ausführungsform der platinenartigen Verbindungseinrichtung ist jeder Stecker 21, 22 der ersten Gruppe mit jeweils einer Leiterbahn 23, 24 auf der zugehörigen Seite der platinenartigen Verbindungseinrichtung verbunden. Jeder Stecker 25, 26 der zweiten Gruppe ist mit entsprechenden, auf der anderen Seite der platinenartigen Verbindungseinrichtung angeordneten gestrichelt gezeichneten Leiterbahnen 27, 28 verbunden. Die Leiterbahnen sind gegeneinander isoliert. Die Leiterbahnen der beiden Seiten sind so geführt, daß jede der Bahnen der einen Seite jede der Bahnen der anderen Seite in Projektion gesehen an wenigstens einer Stelle schneidet. An jeder der Schnittstellen weist die platinenartige Verbindungseinrichtung jeweils Bohrungen 29, 30 auf. Über diese Bohrungen kann jede Leitung der einen Seite mit der entsprechenden Leitung der anderen Seite wahlweise elektrisch leitend so verbunden werden, daß die gewünschte Verbindung der Stek-

ker der einen Seite mit den Steckern der anderen Seite und somit die gewünschte Belegung der Stecker der Klemmleiste bei vorgegebener geometrischer Anordnung der Potential- und Steuerleitungen geschaffen wird.

Damit gegebenenfalls jeder Stecker der einen Seite mit jedem Stecker der anderen Seite verbindbar sein kann, kann in Abwandlung gegenüber der in Fig. 3 gezeigten Ausführungsform die platinenartige Verbindungseinrichtung auch einen mehrschichtigen Aufbau aufweisen. Der Aufbau einer solchen mehrschichtigen Verbindungseinrichtung kann beispielsweise eine mittlere Schicht mit quer verlaufenden Leitungen aufweisen, während die beiden äußeren Schichten senkrecht dazu verlaufende Bahnen aufweisen, die jeweils mit einem der Stecker der zugehörigen Gruppe verbunden sind. Durch Verbinden einer jeweiligen mit einem zugehörigen Stecker verbundenen Leitung mit einer Querleitung und einer mit einem Stecker der anderen Gruppe verbundenen Leitung erfolgt dann die gewünschte Überbrückung und somit Verbindung zwischen dem Stecker der einen Gruppe und dem Stecker der anderen Gruppe.

## Ansprüche

1. Elektronische Einrichtung mit einer Mehrzahl von mit jeweils die Leitungsseite einer Mehrzahl von Steckern einer Steckerleiste verbundenen Potential- und/oder Steuerleitungen mit einer Unterbrechung wenigstens eines Teiles der Leitungen sowie einer Verbindungseinrichtung (17) zum wählbaren Verbinden der Leitungen (14) mit vorbestimmten Steckern (12), wobei die Verbindungseinrichtung (17) eine der Zahl der zu verbindenen Leitungen (14) entsprechende Gruppe erster Verbindungsstifte (18) und eine Gruppe zweiter Verbindungsstifte (19) aufweist und die Stifte (18) der ersten Gruppe mit den Stiften (19) der zweiten Gruppe frei wählbar und an der Stelle der Unterbrechung die Leitungen (13, 14) mit den Verbindungsstiften (18, 19) verbindbar sind, dadurch gekennzeichnet, daß sich über einen ersten Bereich der Verbindungseinrichtung (17) eine erste Gruppe und über einen dagegen isolierten zweiten Bereich eine zweite Gruppe von Leiterbahnen (23, 24, 27, 28) erstrecken, daß die Verbindungsstifte (25, 26) der einen Gruppe mit je einer Leiterbahn (27, 28) der einen Gruppe und die Verbindungsstifte (19, 21, 22) der anderen Gruppe jeweils mit Leiterbahnen (23, 24) der anderen Gruppe verbunden sind, daß jede der Leiterbahnen (23, 24) der einen Gruppe jede der Leiterbahnen (27, 28) der anderen Gruppe in Projektion gesehen schneidet, und daß am Schnittpunkt die wahlweise Verbindung der beiden sich schneidenden Leiterbahnen vorgesehen ist.

2. Elektronische Einrichtung nach Anspruch 1, dadurch gekennzeichnet, daß die Verbindungseinrichtung (17) platinenartig ausgebildet ist.

3. Einrichtung nach Anspruch 1 oder 2, dadurch gekennzeichnet, daß die Verbindungsstifte (18, 19) jeweils einer Gruppe auf jeweils einer Seite eines Randes der Verbindungseinrichtung (17) angeordnet sind.

4. Einrichtung nach einem der Ansprüche 1 bis 3, dadurch gekennzeichnet, daß die elektronische Einrichtung ein Stromversorgungsteil ist.

5. Einrichtung nach Anspruch 2, dadurch gekennzeichnet, daß die platinenartige Verbindungseinrichtung einen mehrschichtigen Aufbau aufweist und eine Zwischenschicht quer zu der ersten und der zweiten Gruppe von Leiterbahnen verlaufende Leiterbahnen aufweist und daß die wahlweise Verbindung über den Schnittpunkt und zu einem Verbindungsstecker gehörenden Leiterbahn der ersten Gruppe mit einer quer verlaufenden Leiterbahn und dieser mit der zu dem vorbestimmten Verbindungsstecker der zweiten Gruppe gehörenden Leiterbahn der zweiten Gruppe erfolgt.

FIG.1

EP 0 310 965 A2

# FIG. 3

# FIG. 2